# EUROPÄISCHE PATENTANMELDUNG

(11) **EP 4 819 494 A1**
(43) Veröffentlichungstag der Anmeldung: **07.10.2026**
(21) Anmeldenummer: 26168297.5
(22) Anmeldetag: 26.03.2026
(51) Int. Cl.: H03K 17/97, H03K 17/972

(54) **ANORDNUNG ZUR AUSWERTUNG EINES INDUKTIVEN SENSORSYSTEMS FÜR EIN FAHRZEUG**

(30) Priorität: 03.04.2025 DE 102025113177
(71) Anmelder: Huf Hülsbeck & Fürst GmbH & Co. KG, 42551 Velbert (DE)
(72) Erfinder: Chabrowski, Christian, 45472 Mülheim (DE)
(74) Vertreter: Bösherz Goebel Patentanwälte

(57) **Zusammenfassung**

Die Erfindung betrifft eine Anordnung (10) zumindest zur Auswertung eines induktiven Sensorsystems (15) für ein Fahrzeug (200), vorzugsweise zur Erfassung und Auswertung einer Aktivierungshandlung am Fahrzeug (200) und bevorzugt Berührung in einem Außenbereich (210) des Fahrzeuges (200), aufweisend einen diskreten elektronischen Schaltungsaufbau.

## Beschreibung

Die vorliegende Erfindung betrifft eine Anordnung zumindest zur Auswertung eines induktiven Sensorsystems für ein Fahrzeug. Ferner bezieht sich die Erfindung auf ein Fahrzeug sowie ein Verfahren zu diesem Zweck.

### Stand der Technik

Grundsätzlich sind aus dem Stand der Technik bereits Sensorsysteme für Fahrzeuge bekannt, welche allerdings oft eine aufwendige Herstellung und den Einsatz von vielen integrierten Schaltkreisen voraussetzen, um zuverlässig Signale von induktiven Sensoren auszuwerten.

Aus dem Stand der Technik sind ferner verschiedene Multiplexersysteme für die sequentielle Abtastung von Sensoren bekannt. So geht aus der US 2011/0096008 A1 hervor, dass die Verwendung eines Multiplexers zur zeitmultiplizierten Abfrage mehrerer Induktionsspulen eine Methode darstellt, um mit einer einzigen Schaltung mehrere Sensorsignale zu verarbeiten. Weitere herkömmliche Lösungen finden sich in den Schriften US 2010/0320066 A1 und EP 2 028 586 A1. Diese herkömmlichen Systeme können allerdings den Nachteil haben, dass sie zu komplexeren Bauformen, höherem Stromverbrauch und/oder größerem Platzbedarf führen. Derartige Systeme sind daher oft nicht für den Einsatz im Fahrzeug geeignet.

### Offenbarung der Erfindung

Es ist daher eine Aufgabe der vorliegenden Erfindung, die voranstehend beschriebenen Nachteile zumindest teilweise zu beheben. Insbesondere ist es Aufgabe der vorliegenden Erfindung, eine auf die Bedürfnisse am Fahrzeug angepasste Schaltung zur Auswertung eines induktiven Sensorsystems bereitzustellen.

Gegenstand der Erfindung ist eine Anordnung mit den Merkmalen des Anspruchs 1, ein Fahrzeug mit den Merkmalen des Anspruchs 14 sowie ein Verfahren mit den Merkmalen des Anspruchs 15. Weitere Merkmale und Details der Erfindung ergeben sich aus den jeweiligen Unteransprüchen, der Beschreibung und den Zeichnungen. Dabei gelten Merkmale und Details, die im Zusammenhang mit der erfindungsgemäßen Anordnung beschrieben sind, selbstverständlich auch im Zusammenhang mit dem erfindungsgemäßen Fahrzeug sowie dem erfindungsgemäßen Verfahren, und jeweils umgekehrt, so dass bezüglich der Offenbarung der Erfindung stets auch eine wechselseitige Bezugnahme möglich ist.

Gegenstand der Erfindung ist insbesondere eine Anordnung, die zumindest zur Auswertung eines induktiven Sensorsystems für ein Fahrzeug vorgesehen ist, und vorzugsweise zur Erfassung und Auswertung einer Aktivierungshandlung am Fahrzeug, bevorzugt Berührung in einem Außenbereich des Fahrzeuges. Es ist möglich, dass der Schaltungsaufbau in einem Fahrzeug zum Beispiel an einer Fahrzeugkomponente wie einer Tür, an einer Klappe, an einer Säule oder am Emblem verwendet wird, um Berührungen oder Gesten zu erkennen. Das Sensorsystem kann mehrere induktive Sensorelemente aufweisen.

Konkrete Beispiele für den Einsatz solcher Aktivierungshandlungen können sein: das Öffnen einer Tür durch Berühren des Sensorsystems, bspw. an einem Türgriff, und/oder das Entriegeln des Fahrzeugs durch eine Berührung an der Karosserie und/oder am Türgriff, und/oder das Aktivieren von Funktionen wie eine Authentifizierung des Benutzers über einen ID-Geber oder eines mobilen Kommunikationsgeräts wie eines Smartphones und/oder das Öffnen einer Klappe oder eines Aufleuchten des Scheinwerfer- oder Blinkerlichts durch die Berührung.

Die Anordnung kann zumindest einen diskreten elektronischen Schaltungsaufbau aufweisen, nachfolgend auch kurz als "Schaltungsaufbau" bezeichnet.

Der Schaltungsaufbau kann umfassen: einen Signalanschluss, der dafür ausgebildet ist, zumindest oder genau ein elektrisches Signal zum Betreiben und vorzugsweise Anregen von zumindest oder genau (nur) einem der mehreren Sensorelemente und/oder von zumindest zwei induktiven Sensorelementen und/oder allen Sensorelementen des Sensorsystems bereitzustellen. Bspw. kann das jeweilige Sensorelement durch das elektrische Signal angeregt werden und die Veränderung wie eine Frequenzänderung des Signals beim Annähern eines elektrisch leitenden und insbesondere metallischen Objekts zur Erkennung der Aktivierungshandlung genutzt werden.

Der Schaltungsaufbau kann ferner umfassen: einen Auswerteanschluss zur Verbindung mit einer Auswertevorrichtung für die Auswertung der Sensorelemente. Daher ist es möglich, dass die Auswertung durch eine Auswertevorrichtung wie einen Mikrocontroller oder eine andere Vorrichtung zur Datenverarbeitung erfolgt, welche hierzu an den Auswerteanschluss angeschlossen wird. Mit anderen Worten kann die Auswertevorrichtung das (veränderte) elektrische Signal von den Sensorelementen empfangen und verarbeiten, um Informationen über die Aktivierungshandlung zu liefern. Beispielsweise kann die Auswertevorrichtung auf diese Weise auch die Position der Berührung an einer Fahrzeugkomponente wie einen Türgriff ermitteln oder Störeinflüsse kompensieren.

Der Schaltungsaufbau kann ferner umfassen: mehrere Kanäle, welche den Signalanschluss und/oder den Auswerteanschluss mit den einzelnen Sensorelementen über verschiedene Signalwege für das elektrische Signal (elektrisch) verbinden. Daher ist es denkbar, dass mehrere Sensorelemente in verschiedenen Positionen am Fahrzeug - und insbesondere an Fahrzeugkomponenten wie einem Türgriff oder einer Säule oder einem Emblem oder einer Klappe - angebracht werden können, um Berührungspunkte oder Gesten zu erkennen. Dabei kann eine solche Mehrkanaltechnik auch zur Erkennung von genauen Aktivierungsorten und Geste, wie z.B. ein Wischen am Türgriff, eingesetzt werden.

Der Schaltungsaufbau kann ferner umfassen: eine Umschaltvorrichtung zur Steuerung des Signalwegs, um die Sensorelemente für die Auswertung auszuwählen und/oder sequenziell oder selektiv mit dem elektrischen Signal zu betreiben. Die Umschaltvorrichtung kann hierbei als ein Multiplexer ausgebildet sein, welche bspw. ein Frequenzmultiplexing ermöglicht. Die Auswertung ist bspw. dadurch möglich, dass die Auswertevorrichtung das elektrische Signal (vereinfacht angenommen als Sinussignal) und ggf. weitere Parameter wie die Mittelspannung misst, um die Anzahl der Flanken zu ermitteln, welche dann mit festen Grenzwerten verglichen werden können. Mit anderen Worten kann die Frequenzmodulation zur Auswertung verwendet werden, um auf diese Weise Störeinflüsse für die Amplitude zu reduzieren.

Es ist möglich, dass die Umschaltvorrichtung als eine Multiplexer-Vorrichtung wie ein Multiplexer oder dergleichen ausgebildet ist, vorzugsweise in der Form wenigstens eines diskreten elektronischen Bauelements.

Die Erfindung kann den Vorteil haben, dass die Anzahl der benötigten Komponenten und der Stromverbrauch reduziert wird. Die flexible Steuerung ermöglicht es zudem, verschiedene Sensorelemente in Abhängigkeit von den Anforderungen des Fahrzeugs zu aktivieren und auszuwerten.

Vorteilhaft ist es darüber hinaus, wenn im Rahmen der Erfindung der Schaltungsaufbau dafür ausgebildet ist, über mindestens einen oder zumindest zwei oder drei oder mindestens vier oder mindestens fünf und/oder über eine flexibel erweiterbare Anzahl der Kanäle mindestens einen oder zumindest zwei oder mindestens drei oder mindestens vier oder mindestens fünf und/oder alle (sämtliche) oder eine flexibel erweiterbare Anzahl der Sensorelemente des Sensorsystems für die Auswertung und/oder das Betreiben mit dem Signalanschluss und/oder dem Auswerteanschluss zu verbinden. Dadurch kann die Schaltung flexibel an unterschiedliche Anforderungen am Fahrzeug angepasst werden, indem weitere Sensoren hinzugefügt oder entfernt werden können. Die Skalierbarkeit der Schaltung ermöglicht somit eine breite Anwendungspalette in verschiedenen Bereichen.

Von weiterem Vorteil kann vorgesehen sein, dass der Schaltungsaufbau dafür ausgebildet ist, dass über jedem der Kanäle eine unterschiedliche Funktion des Sensorsystems angesteuert und/oder ausgewertet wird. Daher ist es möglich, dass jeder Kanal einer unterschiedlichen Funktion des Sensorsystems zugeordnet sein kann, beispielsweise die Erfassung von Berührungen an verschiedenen Stellen des Fahrzeuges bzw. der Fahrzeugkomponente oder die Unterscheidung zwischen verschiedenen Gesten wie Wischen oder Drücken. Mit anderen Worten kann jeder Kanal ggf. ein einzelnes Sensorelement ansteuern und seine Signale unabhängig voneinander auswerten, was zu einer flexibleren und präziseren Sensorfunktion führt. Beispiele hierfür sind die Erkennung von Berührungspunkten an einer Fahrzeugkomponente wie einem Türgriff oder der Unterscheidung zwischen verschiedenen Gesten wie Wischen oder Drücken am Fahrzeug.

Es ist ferner möglich, dass die mit dem Auswerteanschluss verbundene Auswertevorrichtung als ein Teil der Anordnung vorgesehen ist und dazu ausgeführt ist,
- eine erste der Funktionen auszuwerten, wenn die Umschaltvorrichtung einen ersten Kanal mit dem Auswerteanschluss verbindet,
- eine zweite der Funktionen auszuwerten, wenn die Umschaltvorrichtung einen zweiten Kanal mit dem Auswerteanschluss verbindet,
- zumindest eine weitere der Funktionen auszuwerten, wenn die Umschaltvorrichtung einen jeweiligen weiteren Kanal mit dem Auswerteanschluss verbindet.

Dabei können vorzugsweise die Funktionen eine Erfassung der Aktivierungshandlung an unterschiedlichen Lokalisationen am Fahrzeug betreffen und/oder zumindest eine der Funktionen einen Fehlbetätigungsschutz betreffen. Dadurch kann die Anordnung individuell auf spezifische Anforderungen der Anwendung abgestimmt werden. Jedem Kanal kann eine bestimmte Funktion im Sensorsystem zugeordnet werden, z.B. die Erfassung von Berührungen an verschiedenen Stellen des Fahrzeugs bzw. an der Fahrzeugkomponente oder Funktionen wie ein Fehlbetätigungsschutz (d. h. eine Erkennung einer unbeabsichtigten Betätigung). Die Auswertevorrichtung kann dann je nach Kanal unterschiedliche Beeinflussungen des elektrischen Signals interpretieren und entsprechend reagieren, wodurch eine flexible und anpassungsfähige Lösung entsteht.

In einer weiteren Möglichkeit kann vorgesehen sein, dass der Signalanschluss mit einer Signalerzeugungsvorrichtung verbunden ist, welche insbesondere als ein Teil der Anordnung vorgesehen ist, und welche vorzugsweise einen Oszillator, bevorzugt einen Differenzverstärker-Oszillator, umfasst oder als ein solcher ausgebildet ist.

Nach einer weiteren Möglichkeit kann vorgesehen sein, dass der Signalanschluss mit einer Signalerzeugungsvorrichtung verbunden ist, welche als ein Teil der Anordnung vorgesehen ist, und welche dazu ausgebildet sein kann, das elektrische Signal in der Form eines periodischen elektrischen Signals und vorzugsweise im Wesentlichen sinusförmigen Signal zu erzeugen. Auf diese Weise ist es möglich, dass die Anordnung ein signalerzeugendes Element aufweist, welches zur Erzeugung von periodischen Signalen, vorzugsweise sinusförmigen Signalen, dient. Dieses Signal kann dann über den Signalanschluss und die Signalwege an die Sensorelemente weitergeleitet werden.

Es kann von Vorteil sein, wenn im Rahmen der Erfindung die Anordnung ferner die Sensorelemente umfasst. Diese können jeweils wenigstens eine Spule umfassen, um eine Annäherung und/oder relative Positionsänderung zu einem, vorzugsweise elektrisch leitfähigen, Objekt zu detektieren. Auf dieser Basis können sie das elektrische Signal, vorzugsweise zumindest hinsichtlich seiner Frequenz, verändern/beeinflussen. Dabei können die Spulen vorzugsweise jeweils als eine Spiralspule ausgebildet sein, und/oder die Spulen sich über mehrere Ebenen einer Leiterplatte erstrecken.

Weiter ist es denkbar, dass die mit dem Auswerteanschluss verbundene Auswertevorrichtung als ein Teil der Anordnung vorgesehen ist und dazu ausgeführt ist, die Veränderung des elektrischen Signals, vorzugsweise Frequenzveränderung, zu ermitteln, vorzugsweise durch ein Zählen von Flanken des elektrischen Signals mittels eines Zeitgebers (Timers), und auf dieser Basis die Aktivierungshandlung und bevorzugt Berührung zu detektieren. Auf diese Weise kann das System die Annäherung oder relative Positionsveränderung eines leitfähigen Objekts an die/zur Spule der Sensorelemente erkennen. Die Frequenzänderung des elektrischen Signals, verursacht durch die Annäherung des Objekts, wird bspw. von der Auswertevorrichtung detektiert und ausgewertet. Diese Auswertung ermöglicht die Erkennung von Berührungen und anderen Aktivierungen in dem Außenbereich des Fahrzeugs.

Des Weiteren ist es denkbar, dass die mit dem Auswerteanschluss verbundene Auswertevorrichtung als ein Teil der Anordnung vorgesehen ist und dazu ausgeführt ist, für die Auswertung das elektrische Signal mit einem Referenzsignal zu vergleichen. Auf diese Weise ist es möglich, dass die Genauigkeit der Berührungserkennung durch den Vergleich des empfangenen Signals mit einem Referenzsignal verbessert wird. Dies ermöglicht eine zuverlässigere Identifizierung von Berührungen und somit eine präzisere Auswertung der Sensorwerte.

Ferner ist es denkbar, dass die Umschaltvorrichtung dazu ausgebildet ist, auch mehrere oder alle (sämtliche) der Sensorelemente gleichzeitig für die Auswertung auszuwählen und/oder zu betreiben, sodass bevorzugt die mehreren oder alle der Sensorelemente gleichzeitig mit dem Signalanschluss und/oder dem Auswerteanschluss über die Kanäle zumindest vorrübergehend verbunden werden. Mit anderen Worten kann die Umschaltvorrichtung dazu ausgebildet sein, mehrere Kanäle zusammenzuschalten. Dadurch können die Sensoren je nach Aufbau des Sensorsystems bspw. simultan ausgewertet werden und/oder eine Genauigkeit bei der Auswertung erhöht werden. Gleichzeitig ermöglicht dies ein schnelles Ansprechen auf verschiedene Ereignisse oder Inputs.

Des Weiteren ist es im Rahmen der Erfindung optional möglich, dass die Umschaltvorrichtung dazu ausgebildet ist, die folgende Sequenz - vorzugsweise automatisch wiederholt - durchzuführen:
- Auswählen und/oder Betreiben von mehreren oder allen der Sensorelemente gleichzeitig für die Auswertung, sodass bevorzugt diese / alle der Sensorelemente gleichzeitig mit dem Signalanschluss und/oder dem Auswerteanschluss über die Kanäle vorrübergehend verbunden werden, (in diesem Zusammenhang kann auch von einem Zusammenschalten von Kanälen gesprochen werden)
   und anschließend
- Auswählen und/oder Betreiben von nur einzelnen der Sensorelemente für die Auswertung, sodass nur einzelne der Sensorelemente mit dem Signalanschluss und/oder dem Auswerteanschluss über die Kanäle vorrübergehend verbunden werden, wobei dies auch als Einzelmessung bezeichnet werden kann.

Auf diese Weise ist es möglich, dass sowohl die gleichzeitige als auch die sequenzielle Auswertung der Sensorelemente für die Auswertung verwendet wird. Im ersten Schritt kann das Auswählen und/oder Betreiben von mehreren oder allen Sensorelementen gleichzeitig ein Anregen und Auswerten der mehreren/allen Sensorelementen über mehrere / alle Kanäle parallel umfassen und im Falle einer Detektion anschließend auf die Einzelmessung umgeschaltet werden. Auf diese Weise kann der Energieverbrauch deutlich reduziert werden.

Des Weiteren ist es denkbar, dass die Anordnung zur Befestigung in zumindest einer der nachfolgenden Fahrzeugkomponenten ausgeführt ist, und bevorzugt dafür speziell angepasste Befestigungsmittel aufweist: einen Türaußengriff, ein Emblem, ein Spiegel, zumindest eine Klappe, vorzugsweise eine vordere oder hintere Klappe des Fahrzeuges, ein Tankdeckel oder Verschluss für einen Ladeanschluss, zumindest eine Säule, vorzugsweise B-Säule.

Weiter kann zur Erfassung und Auswertung der Aktivierungshandlung am Fahrzeug und bevorzugt der Berührung in einem Außenbereich des Fahrzeuges die Sensorelemente in einem definierten Abstand zu mindestens einem beweglich angeordneten elektrisch leitfähigen Objekt angeordnet sein, welches durch die Aktivierungshandlung am Fahrzeug betätigbar ist, und vorzugsweise auf den Außenbereich des Fahrzeuges ausgerichtet ist, um von dort die Aktivierungshandlung und insbesondere Berührung und vorzugsweise eine Geste eines Benutzers zu erfassen.

Es kann hierdurch erreicht werden, dass die diskrete Schaltung für induktive Sensorsysteme flexibel in verschiedenen Fahrzeugkomponenten integriert werden kann. Die spezielle Anpassung der Befestigungsmittel an die jeweilige Komponente ermöglicht zudem eine sichere und stabile Montage des Systems.

Außerdem kann es im Rahmen der Erfindung von Vorteil sein, dass die Anordnung gemeinsam mit der Auswertevorrichtung und einer mit dem Signalanschluss verbundenen Signalerzeugungsvorrichtung ein kompaktes Bauteil bildet, welches zur Befestigung am Fahrzeug ausgebildet ist. Daher kann das System durch seine kompakte Bauweise eine platzsparende Integration in Fahrzeuge ermöglicht werden. Die gemeinsame Anordnung von Auswertevorrichtung, Signalerzeugungsvorrichtung und Schaltung erlaubt eine einfache Installation und reduziert den Aufwand für die Verkabelung im Fahrzeug.

Weiter ist im Rahmen der Erfindung denkbar, dass eine mit dem Auswerteanschluss verbundene Auswertevorrichtung als ein Mikrocontroller oder eine andere Vorrichtung zur Datenverarbeitung ausgebildet ist, welcher zur Auswertung zumindest einen Komparator für die Auswertung aufweist. Es ist somit möglich, dass der Mikrocontroller die Frequenzänderungen des elektrischen Signals oder einen anderen Parameter aufgrund von Annäherungen oder Berührungen an den induktiven Sensorelementen auswertet und so die Betätigungsstelle erkennt.

Optional ist es denkbar, dass eine mit dem Auswerteanschluss verbundene Auswertevorrichtung zumindest einen diskreten Komparator aufweist, welcher zur Auswertung verwendet wird. Dadurch wird erreicht, dass eine genauere und zuverlässigere Analyse der Signale ermöglicht wird.

Ebenfalls Gegenstand der Erfindung ist ein Fahrzeug, aufweisend eine erfindungsgemäße Anordnung. Damit bringt das erfindungsgemäße Fahrzeug die gleichen Vorteile mit sich, wie sie ausführlich mit Bezug auf eine erfindungsgemäße Anordnung beschrieben worden sind.

Ebenfalls Gegenstand der Erfindung ist ein Verfahren zur Auswertung eines induktiven Sensorsystems für ein Fahrzeug, vorzugsweise zur Erfassung und Auswertung einer Aktivierungshandlung und bevorzugt einer Berührung in einem Außenbereich des Fahrzeuges, vorzugsweise mittels einer erfindungsgemäßen Anordnung.

Es kann bei dem erfindungsgemäßen Verfahren vorgesehen sein, dass ein elektrisches Signal zum Betreiben und vorzugsweise zum Anregen von zumindest oder genau (nur) einem oder mehreren oder zumindest zwei oder allen der mehreren induktiven Sensorelementen des Sensorsystems erzeugt wird.

Weiter kann bei dem erfindungsgemäßen Verfahren vorgesehen sein, dass eine Bereitstellung von mehreren Kanälen erfolgt, welche einen Signalanschluss und/oder einen Auswerteanschluss mit den einzelnen Sensorelementen über verschiedene Signalwege elektrisch verbinden. Die Bereitstellung kann z. B. auf einer Leiterplatte vorgesehen sein.

Weiter ist es möglich, dass ein Initiieren einer Umschaltung einer Umschaltvorrichtung zur Steuerung des Signalwegs als weiterer Verfahrensschritt bei dem erfindungsgemäßen Verfahren vorgesehen ist. Dies kann es ermöglichen, dass die Sensorelemente für die Auswertung ausgewählt und vorzugsweise sequenziell oder selektiv betrieben werden können.

Weiter kann das erfindungsgemäße Verfahren ein Durchführen der Auswertung mittels einer Auswertevorrichtung umfassen, die mit dem Auswerteanschluss verbunden ist. Hierzu kann das elektrische Signal in Abhängigkeit von der Auswahl ausgewertet werden.

Es ist möglich, dass zumindest die Umschaltvorrichtung und vorzugsweise auch der Signalanschluss und der Auswerteanschluss und die Kanäle in einem diskreten Schaltungsaufbau ausgebildet sind.

Damit bringt das erfindungsgemäße Verfahren die gleichen Vorteile mit sich, wie sie ausführlich mit Bezug auf eine erfindungsgemäße Anordnung beschrieben worden sind.

Ebenfalls Gegenstand der Erfindung kann eine Vorrichtung zur Datenverarbeitung sein, umfassend Mittel zur Ausführung der Schritte des erfindungsgemäßen Verfahrens. Damit bringt die erfindungsgemäße Vorrichtung zur Datenverarbeitung die gleichen Vorteile mit sich, wie sie ausführlich mit Bezug auf ein erfindungsgemäßes Verfahren beschrieben worden sind.

Ebenfalls Gegenstand der Erfindung kann ein Computerprogramm wie ein Programm für einen Mikrocontroller sein, insbesondere Computerprogrammprodukt, umfassend Befehle, die bei der Ausführung des Computerprogrammes durch wenigstens einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind. Das Computerprogramm kann ferner zumindest teilweise nicht-flüchtig und/oder als Software zum Download und/oder als Cloud-Service und/oder als ausführbares Programm und/oder als Konfigurationsdatei und/oder als Programmbibliothek und/oder als Quelltext und/oder in kompilierter und/oder verschlüsselter und/oder komprimierter Form und/oder in einer Kombination davon vorliegen.

Als der Computer kann eine Datenverarbeitungsvorrichtung, vorzugsweise die erfindungsgemäße Vorrichtung zur Datenverarbeitung, ein Mikrocontroller, oder ein anderes Computersystem vorgesehen sein. Unter einem Computer kann daher im Rahmen der Erfindung auch ein Mikrocontroller verstanden werden.

Die erfindungsgemäße Vorrichtung zur Datenverarbeitung und vorzugsweise der Computer kann dazu ausgebildet sein, das erfindungsgemäße Computerprogramm auszuführen. Hierzu kann die erfindungsgemäße Vorrichtung zur Datenverarbeitung wenigstens einen Prozessor aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann.

Ebenfalls ist es denkbar, dass die erfindungsgemäße Vorrichtung zur Datenverarbeitung zumindest einen integrierten Schaltkreis wie einen Mikroprozessor oder eine Anwendungsspezifische integrierte Schaltung (ASIC) oder ein Anwendungsspezifisches Standardprodukt (ASSP) oder einen digitalen Signalprozessor (DSP) oder einen Field Programmable Gate Array (FPGA) oder dergleichen umfasst. Die erfindungsgemäße Vorrichtung zur Datenverarbeitung bzw. der Computer kann somit auch als eine elektronische Schaltung ausgebildet sein. Die erfindungsgemäße Vorrichtung zur Datenverarbeitung kann ferner wenigstens eine Schnittstelle zum Datenaustausch, z. B. eine Ethernet-Schnittstelle oder eine Schnittstelle für LAN (Local Area Network) oder WLAN (Wireless Local Area Network) oder System-on-a-Chip (SoC) oder eine andere Funkschnittstelle wie bspw. zur Bluetooth- oder Nahfeldkommunikation (NFC) aufweisen. Ferner kann die erfindungsgemäße Vorrichtung zur Datenverarbeitung als ein oder mehrere Steuergeräte, d. h. auch als ein System aus Steuergeräten, ausgeführt sein.

Die erfindungsgemäße Vorrichtung zur Datenverarbeitung kann vollständig oder teilweise auch in einer Cloud und/oder als ein Server vorgesehen sein, um über die Schnittstelle die Datenverarbeitung für eine lokale Anwendung zur Verfügung zu stellen. Entsprechend kann die erfindungsgemäße Vorrichtung zur Datenverarbeitung auch als ein Computersystem wie ein verteiltes System und vorzugsweise Server-Client-System ausgebildet sein. Auch ist es möglich, dass die erfindungsgemäße Vorrichtung zur Datenverarbeitung als ein mobiles Gerät, wie ein Smartphone, ausgeführt ist.

Ebenfalls Gegenstand der Erfindung kann ein computerlesbares Speichermedium sein, welches das erfindungsgemäße Computerprogramm umfasst. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer und/oder in die erfindungsgemäße Vorrichtung zur Datenverarbeitung integriert sein.

Darüber hinaus kann das erfindungsgemäße Verfahren auch als ein automatisiertes Verfahren ausgeführt sein. Alternativ oder zusätzlich können jeder einzelne oder sämtliche der offenbarten Verfahrensschritte optional computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Darstellung zur Visualisierung eines Verfahrens gemäß Ausführungsvarianten der Erfindung.
- Fig. 2: eine schematische Darstellung einer Anordnung gemäß Ausführungsvarianten der Erfindungen.
- Fig. 3: eine schematische Seitenansicht eines Fahrzeuges gemäß Ausführungsvarianten der Erfindungen.

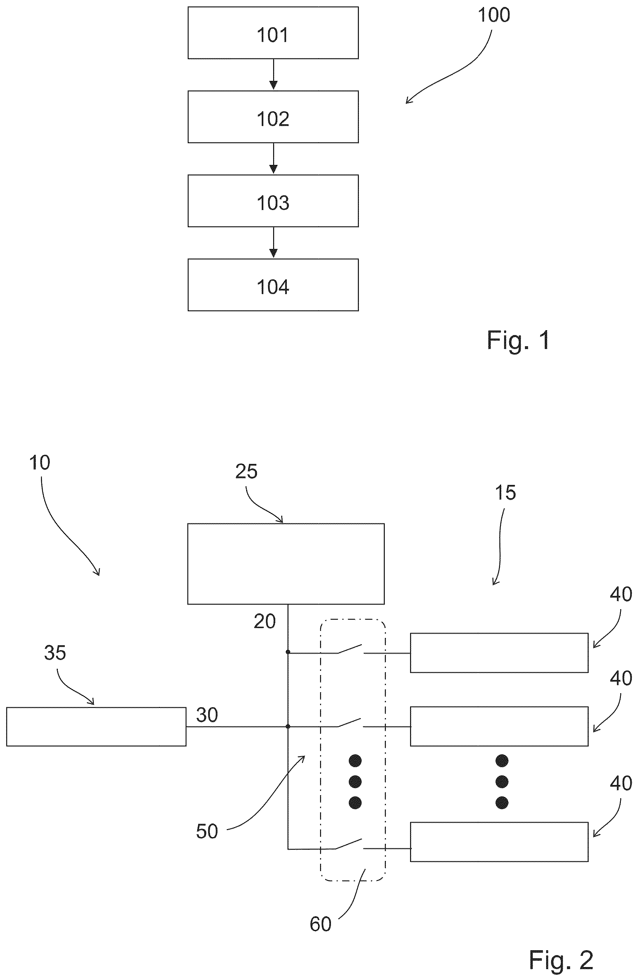

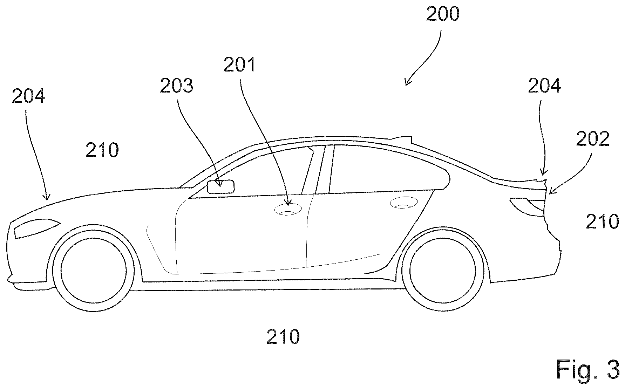

Fig. 1 veranschaulicht gemäß Ausführungsbeispielen der Erfindung ein Verfahren 100 zur Auswertung eines induktiven Sensorsystems 15 für ein in Fig. 3 dargestelltes Fahrzeug 200.

Das Verfahren 100 dient vorzugsweise zur Erfassung und Auswertung einer Aktivierungshandlung - bevorzugt Berührung - in einem Außenbereich 210 des Fahrzeuges 200. Hierzu kann eine in Fig. 2 gezeigte Anordnung 10 nach Ausführungsbeispielen der Erfindung zum Einsatz kommen.

Gemäß einem ersten Verfahrensschritt 101 erfolgt ein Erzeugen eines elektrischen Signals zum Betreiben und vorzugsweise zum Anregen von zumindest zwei induktiven Sensorelementen 40 des Sensorsystems 15. Das elektrische Signal wird vorzugsweise durch eine in Fig. 2 gezeigte Signalerzeugungsvorrichtung 25 erzeugt und über einen Signalanschluss 20 bereitgestellt. Die Signalerzeugungsvorrichtung 25 kann hierzu einen Oszillator, bevorzugt einen Differenzverstärker-Oszillator, umfassen oder als ein solcher ausgebildet sein.

Gemäß einem zweiten Verfahrensschritt 102 können ferner mehrere Kanäle 50 bereitgestellt werden, welche den Signalanschluss 20 und/oder einen Auswerteanschluss 30 mit den einzelnen Sensorelementen 40 über verschiedene Signalwege elektrisch verbinden.

Gemäß einem dritten Verfahrensschritt 103 erfolgt ein Initiieren einer Umschaltung einer ebenfalls in Fig. 2 gezeigten Umschaltvorrichtung 60 zur Steuerung des Signalwegs, um die Sensorelemente 40 für die Auswertung auszuwählen und vorzugsweise sequenziell oder selektiv zu betreiben.

Die Auswertung kann ferner gemäß einem vierten Verfahrensschritt 104 mittels einer Auswertevorrichtung 35 durchgeführt werden, die mit dem Auswerteanschluss 30 verbunden ist. Hierzu kann das elektrische Signal in Abhängigkeit von der Auswahl ausgewertet werden. Die Umschaltvorrichtung 60 und vorzugsweise auch der Signalanschluss 20 und der Auswerteanschluss 30 und die Kanäle 50 können in einem diskreten Schaltungsaufbau ausgebildet sein. Die mit dem Auswerteanschluss 30 verbundene Auswertevorrichtung 35 kann als ein Teil der Anordnung 10 vorgesehen sein und dazu ausgeführt sein, für die Auswertung das elektrische Signal mit einem Referenzsignal zu vergleichen. Die Auswertevorrichtung 35 kann ferner als ein Mikrocontroller ausgebildet sein, welcher zur Auswertung zumindest einen Komparator für die Auswertung aufweist.

Der in Fig. 2 gezeigte Schaltungsaufbau kann ferner dafür ausgebildet sein, über mindestens drei oder mindestens vier oder mindestens fünf und/oder über eine flexibel erweiterbare Anzahl der Kanäle 50 mindestens drei oder mindestens vier oder mindestens fünf und/oder eine flexibel erweiterbare Anzahl der Sensorelemente 40 des Sensorsystems 15 für die Auswertung und/oder das Betreiben mit dem Signalanschluss 20 und/oder dem Auswerteanschluss 30 zu verbinden.

Aus dem Stand der Technik sind zwar bereits induktive Sensorchips bekannt, welche mehrere Kanäle bereitstellen können. Im Gegensatz hierzu können bei Ausführungsvarianten der Erfindung zumindest die Kanäle und/oder die Umschaltvorrichtung und/oder weitere Teile als eine diskrete Schaltung aufgebaut sein, also Teil eines diskreten Schaltungsaufbaus sein.

Ein weiterer Vorteil des diskreten Aufbaus ist, dass die Erweiterung der Kanäle, also das Hinzufügen von weiteren Kanälen für weitere Sensorelemente 40, was im Gegensatz zu herkömmlichen Lösungen technisch deutlich weniger aufwendig ist. Ferner ergibt sich durch den vorgeschlagenen Aufbau eine Flächenersparnis.

Ein Vorteil der Mehrkanaligkeit ist insbesondere, dass jeder Kanal eine Funktion erhalten kann. Weiter können auch unbeabsichtigte Betätigungen erkannt werden.

Die Umschaltvorrichtung 60 kann dazu ausgebildet sein, auch mehrere oder alle der Sensorelemente 40 gleichzeitig für die Auswertung auszuwählen und/oder zu betreiben, sodass die mehreren oder alle der Sensorelemente 40 gleichzeitig mit dem Signalanschluss 20 und/oder dem Auswerteanschluss 30 über die Kanäle 50 zumindest vorrübergehend verbunden werden.

In Fig. 3 ist schematisch visualisiert, dass die Anordnung 10 zur Befestigung in zumindest einer der nachfolgenden Fahrzeugkomponenten ausgeführt ist, und bevorzugt dafür speziell angepasste Befestigungsmittel aufweist: einen Türgriff 201, vorzugsweise Türaußengriff 201, ein Emblem 202, zumindest eine Klappe 204, vorzugsweise eine vordere oder hintere Klappe des Fahrzeuges 200, ein Spiegel 203, zumindest eine Säule, vorzugsweise B-Säule oder ein Tank- oder Ladeanschlussdeckel.

Die Auswertung kann ggf. auch eine Auswertung umfassen, wie: An welcher Stelle am Türgriff 201 wurde gedrückt? Welche Einfluss auf die Sensorerfassung und/oder Sensitivität haben die unterschiedlichen Stellen? Eine weitere Aufgabe der Auswertung kann es sein, Störeinflüsse zu kompensieren.

Die Signalerzeugungsvorrichtung 25 kann bspw. einen Oszillator und/oder ein MOSFET und/oder einen "Differential amplifier oscillator" umfassen.

Das jeweilige Sensorelement 40 kann bspw. als ein LC-Oszillator ausgebildet sein. Nähert sich ein elektrisch leitendes und vorzugsweise metallisches Objekt an das jeweilige Sensorelement 40, wird eine Schwingung erzeugt, die die Frequenz des elektrischen Signals verändert sich. Dies kann sehr zuverlässig durch die Auswertevorrichtung 35 ausgewertet werden.

Die Umschaltvorrichtung 60 ermöglicht es insbesondere, dass Kanäle einzeln oder gleichzeitig geschaltet werden können. Dadurch kann die Anordnung 10 auch insgesamt stromsparender betrieben werden. Auch kann eine parallele Auswertung von Sensorelementen 40 vorgesehen sein, um die Reaktionszeiten zu verbessern.

Die Sensorelemente können an unterschiedlichen Positionen vorgesehen sein, um zu detektieren, an welcher Stelle eine Aktivierungshandlung wie eine Berührung erfolgt ist. Auch können ggf. Gesten wie ein Wischen erkannt werden. Für die Auswertung können bspw. die Flanken des (periodischen) elektrischen Signals gezählt werden, um die Frequenz zu ermitteln. Auf Basis einer Erkennung des Frequenzunterschied können unterschiedliche Aktivierungshandlungen oder generell das Vorliegen einer Aktivierungshandlung erkannt werden. Die Auswertevorrichtung 35, vorzugsweise ein Mikrocontroller, erhält dabei das elektrische Signal, zählt über einen Zeitgeber die Flanken und vergleicht diese dann mit wenigstens einem Grenzwert.

Für die Auswertung kann eine Frequenzmodulation verwendet werden. Dies hat den Vorteil, dass Störeinflüsse für die Amplitude weniger problematisch sind. Bspw. kann das elektrische Signal im Zeitraum von 1 ms ausgewertet werden, um die Frequenz zu ermitteln. Alternativ oder ergänzend kann eine Phasenmessung erfolgen.

Ferner kann die Anordnung 10 nach Ausführungsvarianten der Erfindung lediglich einen Schwingkreis und einen Komparator aufweisen, um das Sensorsystem bereitzustellen.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Anordnung
- 15: Sensorsystem

- 20: Signalanschluss
- 25: Signalerzeugungsvorrichtung

- 30: Auswerteanschluss
- 35: Auswertevorrichtung

- 40: Sensorelemente

- 50: Kanäle

- 60: Umschaltvorrichtung

- 100: Verfahren
- 101: erster Verfahrensschritt
- 102: zweiter Verfahrensschritt
- 103: dritter Verfahrensschritt
- 104: vierter Verfahrensschritt

- 200: Fahrzeug
- 201: Türgriff
- 202: Emblem
- 203: Spiegel
- 204: Klappe
- 210: Außenbereich

## Patentansprüche

1. Anordnung (10) zumindest zur Auswertung eines induktiven Sensorsystems (15) mit mehreren induktiven Sensorelementen (40) für ein Fahrzeug (200), vorzugsweise zur Erfassung und Auswertung einer Aktivierungshandlung am Fahrzeug (200) und bevorzugt Berührung in einem Außenbereich (210) des Fahrzeuges (200), aufweisend einen diskreten elektronischen Schaltungsaufbau, welcher umfasst:
- einen Signalanschluss (20), der dafür ausgebildet ist, zumindest oder genau ein elektrisches Signal zum Betreiben und vorzugsweise Anregen von zumindest einem induktiven Sensorelement (40) der mehreren induktiven Sensorelementen (40) des Sensorsystems (15) bereitzustellen,
- einen Auswerteanschluss (30) zur Verbindung mit einer Auswertevorrichtung (35) für die Auswertung der Sensorelemente (40),
- mehrere Kanäle (50), welche den Signalanschluss (20) und/oder den Auswerteanschluss (30) mit den einzelnen Sensorelementen (40) über verschiedene Signalwege für das elektrische Signal verbinden,
- eine Umschaltvorrichtung (60) zur Steuerung des Signalwegs, um die Sensorelemente (40) für die Auswertung auszuwählen und/oder sequenziell oder selektiv mit dem elektrischen Signal zu betreiben.

2. Anordnung (10) nach Anspruch 1,
**dadurch gekennzeichnet,**
**dass** der Schaltungsaufbau dafür ausgebildet ist, über mindestens zwei oder mindestens drei oder mindestens vier oder mindestens fünf und/oder über eine flexibel erweiterbare Anzahl der Kanäle (50) mindestens zwei oder mindestens drei oder mindestens vier oder mindestens fünf und/oder sämtliche oder eine flexibel erweiterbare Anzahl der Sensorelemente (40) des Sensorsystems (15) für die Auswertung und/oder das Betreiben mit dem Signalanschluss (20) und/oder dem Auswerteanschluss (30) zu verbinden.

3. Anordnung (10) nach einem der vorhergehenden Ansprüche,
**dadurch gekennzeichnet,**
**dass** der Schaltungsaufbau dafür ausgebildet ist, dass über jedem der Kanäle (50) eine unterschiedliche Funktion des Sensorsystems (15) angesteuert und/oder ausgewertet wird,
und **dass** die mit dem Auswerteanschluss (30) verbundene Auswertevorrichtung (35) als ein Teil der Anordnung (10) vorgesehen ist und dazu ausgeführt ist,
- eine erste der Funktionen auszuwerten, wenn die Umschaltvorrichtung (60) einen ersten Kanal mit dem Auswerteanschluss (30) verbindet,
- eine zweite der Funktionen auszuwerten, wenn die Umschaltvorrichtung (60) einen zweiten Kanal mit dem Auswerteanschluss (30) verbindet,
- zumindest eine weitere der Funktionen auszuwerten, wenn die Umschaltvorrichtung (60) einen jeweiligen weiteren Kanal mit dem Auswerteanschluss (30) verbindet,
wobei vorzugsweise die Funktionen eine Erfassung der Aktivierungshandlung an unterschiedlichen Lokalisationen am Fahrzeug (200) betreffen und/oder zumindest eine der Funktionen einen Fehlbetätigungsschutz betrifft.

4. Anordnung (10) nach einem der vorhergehenden Ansprüche,
**dadurch gekennzeichnet,**
**dass** der Signalanschluss (20) mit einer Signalerzeugungsvorrichtung (25) verbunden ist, welche insbesondere als ein Teil der Anordnung (10) vorgesehen ist, und welche vorzugsweise einen Oszillator, bevorzugt einen Differenzverstärker-Oszillator, umfasst oder als ein solcher ausgebildet ist.

5. Anordnung (10) nach einem der vorhergehenden Ansprüche,
**dadurch gekennzeichnet,**
**dass** der Signalanschluss (20) mit einer Signalerzeugungsvorrichtung (25) verbunden ist, welche als ein Teil der Anordnung (10) vorgesehen ist, und welche dazu ausgebildet ist, das elektrische Signal in der Form eines periodischen elektrischen Signals und vorzugsweise im Wesentlichen sinusförmigen Signal zu erzeugen.

6. Anordnung (10) nach einem der vorhergehenden Ansprüche,
**dadurch gekennzeichnet,**
**dass** die Anordnung (10) ferner die Sensorelemente (40) umfasst, welche jeweils wenigstens eine Spule umfassen, um eine Annäherung und/oder relative Positionsänderung zu einem, vorzugsweise elektrisch leitfähigen, Objekt zu detektieren, und auf dieser Basis das elektrische Signal, vorzugsweise zumindest hinsichtlich seiner Frequenz, zu verändern, wobei die Spulen vorzugsweise jeweils als eine Spiralspule ausgebildet sind, und/oder die Spulen sich über mehrere Ebenen einer Leiterplatte erstrecken,
und **dass** die mit dem Auswerteanschluss (30) verbundene Auswertevorrichtung (35) als ein Teil der Anordnung (10) vorgesehen ist und dazu ausgeführt ist, die Veränderung des elektrischen Signals, vorzugsweise Frequenzveränderung, zu ermitteln, vorzugsweise durch ein Zählen von Flanken des elektrischen Signals mittels eines Zeitgebers, und auf dieser Basis die Aktivierungshandlung und bevorzugt Berührung zu detektieren.

7. Anordnung (10) nach einem der vorhergehenden Ansprüche,
**dadurch gekennzeichnet,**
**dass** die mit dem Auswerteanschluss (30) verbundene Auswertevorrichtung (35) als ein Teil der Anordnung (10) vorgesehen ist und dazu ausgeführt ist, für die Auswertung das elektrische Signal mit einem Referenzsignal zu vergleichen.

8. Anordnung (10) nach einem der vorhergehenden Ansprüche,
**dadurch gekennzeichnet,**
**dass** die Umschaltvorrichtung (60) dazu ausgebildet ist, auch mehrere oder sämtliche der Sensorelemente (40) gleichzeitig für die Auswertung auszuwählen und/oder zu betreiben.

9. Anordnung (10) nach einem der vorhergehenden Ansprüche,
**dadurch gekennzeichnet,**
**dass** die Umschaltvorrichtung (60) dazu ausgebildet ist, die folgende Sequenz - vorzugsweise automatisch wiederholt - durchzuführen:
- Auswählen und/oder Betreiben von mehreren oder allen der Sensorelemente (40) gleichzeitig für die Auswertung,
und anschließend
- Auswählen und/oder Betreiben von nur einzelnen der Sensorelemente (40) für die Auswertung, sodass nur einzelne der Sensorelemente (40) mit dem Signalanschluss (20) und/oder dem Auswerteanschluss (30) über die Kanäle (50) vorrübergehend verbunden werden.

10. Anordnung (10) nach einem der vorhergehenden Ansprüche,
**dadurch gekennzeichnet,**
**dass** die Anordnung (10) zur Befestigung in zumindest einer der nachfolgenden Fahrzeugkomponenten ausgeführt ist, und bevorzugt dafür speziell angepasste Befestigungsmittel aufweist:
- einen Türaußengriff,
- ein Emblem,
- zumindest eine Klappe, vorzugsweise eine vordere oder hintere Klappe des Fahrzeuges,
- ein Tankdeckel oder Verschluss für einen Ladeanschluss,
- zumindest eine Säule, vorzugsweise B-Säule,
wobei zur Erfassung und Auswertung der Aktivierungshandlung am Fahrzeug (200) und bevorzugt der Berührung in einem Außenbereich (210) des Fahrzeuges (200) die Sensorelemente (40) in einem definierten Abstand zu mindestens einem beweglich angeordneten elektrisch leitfähigen Objekt angeordnet sind, welches durch die Aktivierungshandlung am Fahrzeug (200) betätigbar ist, und vorzugsweise auf den Außenbereich (210) des Fahrzeuges (200) ausgerichtet ist, um von dort die Aktivierungshandlung und insbesondere Berührung und vorzugsweise eine Geste eines Benutzers zu erfassen.

11. Anordnung (10) nach einem der vorhergehenden Ansprüche,
**dadurch gekennzeichnet,**
**dass** die Anordnung (10) gemeinsam mit der Auswertevorrichtung (35) und einer mit dem Signalanschluss (20) verbundenen Signalerzeugungsvorrichtung (25) ein kompaktes Bauteil bildet, welches zur Befestigung am Fahrzeug (200) ausgebildet ist.

12. Anordnung (10) nach einem der vorhergehenden Ansprüche,
**dadurch gekennzeichnet,**
**dass** eine mit dem Auswerteanschluss (30) verbundene Auswertevorrichtung (35) als ein Mikrocontroller ausgebildet ist, welcher zur Auswertung zumindest einen Komparator für die Auswertung aufweist, wobei der Komparator vorzugsweise in der Auswertevorrichtung (35), bevorzugt einen Mikrocontroller, integriert ist.

13. Anordnung (10) nach einem der vorhergehenden Ansprüche,
**dadurch gekennzeichnet,**
**dass** eine mit dem Auswerteanschluss (30) verbundene Auswertevorrichtung (35) zumindest einen diskreten Komparator aufweist, welcher zur Auswertung verwendet wird.

14. Fahrzeug (200), aufweisend eine Anordnung (10) nach einem der vorhergehenden Ansprüche.

15. Verfahren (100) zur Auswertung eines induktiven Sensorsystems (15) mit mehreren induktiven Sensorelementen (40) für ein Fahrzeug (200), vorzugsweise zur Erfassung und Auswertung einer Aktivierungshandlung und bevorzugt Berührung in einem Außenbereich (210) des Fahrzeuges (200), vorzugsweise mittels einer Anordnung (10) nach einem der vorhergehenden Ansprüche, umfassend:
- Erzeugen (101) eines elektrischen Signals zum Betreiben und vorzugsweise zum Anregen von zumindest einem der mehreren induktiven Sensorelemente (40) des Sensorsystems (15),
- Bereitstellen (102) von mehreren Kanälen (50), welche einen Signalanschluss (20) und/oder einen Auswerteanschluss (30) mit den einzelnen Sensorelementen (40) über verschiedene Signalwege elektrisch verbinden,
- Initiieren (103) einer Umschaltung einer Umschaltvorrichtung (60) zur Steuerung des Signalwegs, um die Sensorelemente (40) für die Auswertung auszuwählen und vorzugsweise sequenziell oder selektiv zu betreiben,
- Durchführen (104) der Auswertung mittels einer Auswertevorrichtung (35), die mit dem Auswerteanschluss (30) verbunden ist, wobei hierzu das elektrische Signal in Abhängigkeit von der Auswahl ausgewertet wird,
**dadurch gekennzeichnet,**
**dass** zumindest die Umschaltvorrichtung (60) und vorzugsweise auch der Signalanschluss (20) und der Auswerteanschluss (30) und die Kanäle (50) in einem diskreten Schaltungsaufbau ausgebildet sind.
